# EUROPÄISCHE PATENTSCHRIFT

(11) **EP 1 526 905 B1**
(45) Veröffentlichungstag und Bekanntmachung des Hinweises auf die Patenterteilung: **08.06.2011**
(21) Anmeldenummer: 03747867.4
(22) Anmeldetag: 29.07.2003
(51) Int. Cl.: B01D 9/02

(54) **PROTEINKRISTALLISATIONSVERFAHREN**
PROTEIN CRYSTALLISATION METHOD
PROCEDE DE CRISTALLISATION DE PROTEINES

(30) Priorität: 30.07.2002 EP 02017135; 01.09.2002 BE 200200509; 16.01.2003 DE 10301342
(43) Veröffentlichungstag der Anmeldung: 04.05.2005
(73) Patentinhaber: Hoffmann, Kurt, Dr., 4770 Amel (BE)
(72) Erfinder: Hoffmann, Kurt, Dr., 4770 Amel (BE)
(74) Vertreter: von Kreisler Selting Werner
(86) Internationale Anmeldenummer: PCT/EP2003/008369
(87) Internationale Veröffentlichungsnummer: WO 2004/012841

(56) Entgegenhaltungen:
- WO-A-01/88231
- US-A1- 2001 002 261
- PATENT ABSTRACTS OF JAPAN Bd. 1995, Nr. 05, 30. Juni 1995 (1995-06-30) & JP 07 053738 A (28-2-95), 28. Februar 1995 (1995-02-28)

## Beschreibung

Die Erfindung betrifft Verfahren zur Kristallisation von Makromolekülen in einem Drelphasensystem und entsprechende Vorrichtungen.

Die Kenntnisse über die dreidimensionale Struktur biologischer Makromoleküle haben einen dramatischen Impakt sowohl auf die Entwicklung der modernen Biotechnologie als auch in der therapeutischen Behandlung von Krankheiten. So kann z. B. die Bestimmung der dreidimmensionalen Struktur eines Proteintargets entscheidende Informationen für die Identifikation und. Entwicklung neuer Wirkstoffe liefern, die mit dem jeweiligen Proteintarget interagieren.

Die Aufklärung dreidimensionaler Strukturen, biologischer Makromoleküle erfolgt am genausten durch die Röntgenstrukturanalyse. Voraussetzung für die Strukturaufklärung' ist, das die Makromoleküle, wie Proteine oder deren Komplexe, als Einkristalle zur Verfügung stehen.

Des weiteren können Kristallisationsmethoden zur Ableitung und Generierung von kristallinen Formulierungen rekombinanter Wirkstoffe beitragen, wobei die Kristallmorphologie einen nicht unerheblichen einfluß auf die pharmacokinetischen Eigenschaften einer Formolierung haben kann. Auch die Polymorphismenuntersuchung von niedermolekularen Verbindungen synthetischen oder natürlichen Ursprungs kann über Kristallisätionsexperimente realisiert werden. Ein weiteres Anwendungsfeld, der Kristallisation liegt in deren Eigenschaft als Aufreinigungsmethode für biologische Makromoleküle als auch von niedermolekularen Verbindungen. Kristallisationsmethoden können sowohl im Klein- als auch im Großmaßstab durchgeführt werden.

Üblicherweise wird versucht, Kristalle aus gesättigten Lösungen hochgereinigter Proteine in Anwesenheit einer konzentrierten Lösung entsprechender Salze oder Polymere (Polyethylenglycole usw.) zu gewinnen. Dabei wird den Proteinlösungen das für die Löslichkeit notwendige Wasser in einem bestimmten Zeitablauf mehr oder weniger entzogen, so dass durch eine Fluktuation der Proteinmoleküle Assoziate unterschiedlicher Größe entstehen können. Das Entstehen von Nukleationskelmen ist die Voraussetzung für die Bildung von Kristallen. Diese Vorgänge werden normalerweise empirisch erprobt durch die Auswahl von verschiedenen Proteinkonzentrationen, von verschiedenen Salzen in variierenden Ionenstärkebedingungen, pH-Werten, Puffern, Polymeren, organischen Lösungsmitteln, Temperaturen usw., wobei ein Multiparameterproblem vorliegt. (MePherson, A., Crystallization of Biological Macromolecules, Cold Spring Harbor Press, New-York, 1999)

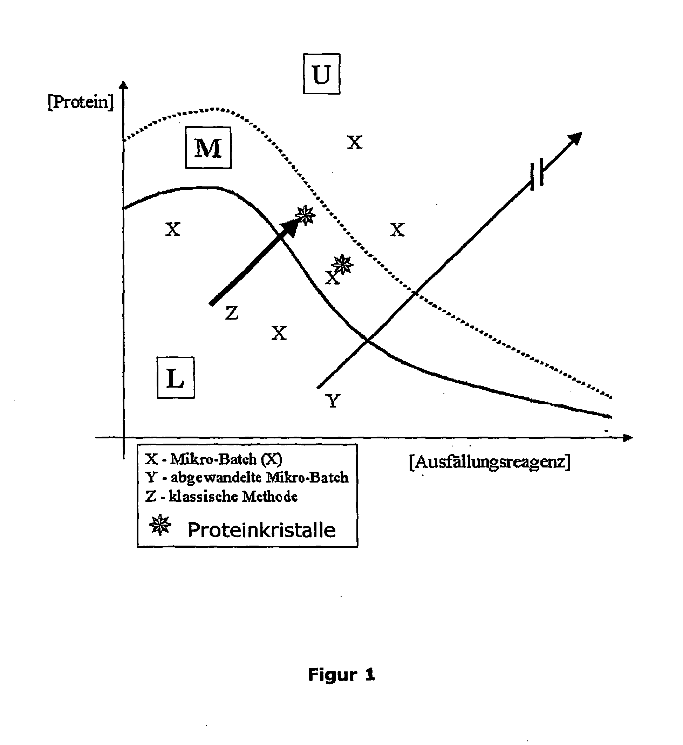

Es stehen verschiedene Kristallisationsverfahren zur Verfügung. Bei sogenannten Batch-Verfahren wird in einem geeigneten Probenträger das zu kristallisierende Protein als konzentrierte Lösung einer vorher deponierten wässrigen Lösung zugegeben oder umgekehrt (Chayen, N. E.; Stewart, P. D. S.; Maeder, D. L.; Blow, D. M.; J. Appl. Cryst., 1990, 23, 297-302; Chayen, N. E.; J. Crystal Growth. 1999, 196, 434-41). Da bei diesem System keine Anreicherung der Niederschlagsreagenzien über einen längeren Zeitraum stattfindet, sondern die Endkonzentrationen bei der Applikation der Proteinlösung direkt eingestellt wird, spricht man von einem "Batchverfahren". Diese Methode ermöglicht keinen kontinuierlichen Eintritt in die metastabile Region eines Phasendiagramms. Somit geht der große Vorzug der klassischen Kristallisationsverfahren verloren (kinetische Eigenschaften und dynamische Endpunktbestimmung, siehe Figur 1).

Eine abgewandelte Methode zum Batchverfahren besteht darin, an Stelle des reinen Paraffinöls ein z.B. mit Poly-Dimethylsiloxan (DMS) versetztes Paraffinöl zu verwenden, so dass eine kontinuierliche Wasserdiffusion aus der Lösung stattfindet (D'Arcy A.; Elmore, C.; Stihle, M.; Johnston, J. E.; J. Crystal. Growth. 1996, 168, 175-80). Die Methode erlaubt jedoch nicht die Einstellung eines Endpunktes, da es sich nicht um ein geschlossenes System handelt. Der große Nachteil ist, dass die Proteinlösung über einen bestimmten Zeitraum komplett austrocknet. Sie ist somit für die Kristallogenese nur bedingt verwendbar (siehe Figur 1).

Dagegen wird bei klassischen Methoden (hanging/sitting-drop) in der Regel ein Tropfen einer Proteinlösung (versetzt mit Reservoirlösung) in einem geschlossenen Gefäß mit einem Reservoir einer wässrigen Lösung einer vorgegebenen höheren Konzentration unter Luftabschluss inkubiert. Mit der Zeit verdunstet Wasser aus dem Tropfen, so dass die Proteinkonzentration kontinuierlich zunimmt. Ein Endpunkt wird erreicht, wenn der Tropfen mit dem Reservoir im Gleichgewicht steht. Über die Konzentration des überschüssigen Reservoirs läßt sich somit der Endpunkt einstellte.

Die Bereitstellung von Kristallen, die für die Strukturaufklärung geeignet sind, ist jedoch oft mit großen Schwierigkeiten verbunden oder nach den bekannten Methoden überhaupt nicht möglich. Häufig kommt es vor, dass eine geordnete Kristallisation aus nicht bekannten Gründen ausbleibt. Das Wechselspiel physikalisch-chemischer Vorgänge, die sich während der Kristallogenese abspielen, ist bis heute nicht eindeutig beschrieben, da sich die Kristallisation bisher einer konsequenten Analyse entzog. Wenn Kristalle erhalten werden, sind diese oft nicht von ausreichender Größe oder Qualität.

In Anbetracht der großen Fortschritte, die in den letzten Jahren bei der Aufklärung/Identifikation von Gen- und Proteinsequenzen durch neue und automatisierte Verfahren erzielt wurden, ist es wünschenswert, die zahlreichen neuen Proteine, die jetzt expremiert werden können, systematisch mit automatisierten Verfahren zu untersuchen. Auch haben Teilbereiche der Röntgenstrukturanalyse in den letzten Jahren gewaltige Effizienzsteigerungen erfahren. Hierzu trug unter anderem die Bereitstellung von Röntgenstrahlungsquellen hoher Brillianz (Synchrotrone), sowie die Bereitstellung effizienter Hard- und Software für die Dateninterpretation bei. Die bekannten Verfahren zur Kristallisation von biologischen Makromolekülen konnten bislang jedoch nicht auf befriedigende Art und Weise als automatisierte Hochdurchsatzverfahren durchgeführt werden (Chayen, N. E. und Saridakis, E.; Acta Cryst. 2002, D58, 921-27). Es besteht daher ein starkes Bedürfnis nach Verfahren zur Kristallisation von Proteinen, die einfach automatisiert werden können und somit ein Screening der mittlerweile verfügbaren Proteine und die systematische Erzeugung von Kristallen ermöglichen.

Bei automatisierten Diffusionsexperimenten nach der Hanging-Drop- oder Sitting-Drop-Methode werden geschlossene Systeme z.B. durch silikonisierte Glasdeckel oder mit selbstklebenden transparenten Folien verschlossen. Bei der Hanging-Drop-Methode muss ein Tropfen jeweils auf die Unterseite eines Deckels pipettiert werden, der Deckel umgedreht werden und ohne Beeinträchtigung des Tropfens über einem Flüssigkeitsreservoir aufgesetzt werden, das luftdicht verschlossen werden muss. Für den Roboter ist dies mit relativ vielen aufwändigen Arbeitsschritten verbunden.. Derartige automatisierten Verfahren sind nicht attraktiv hinsichtlich Kosten, Geschwindigkeit und Reproduzierbarkeit und lassen sich nur schlecht mit kleinsten Probenvolumina realisieren (siehe auch Chayen und Saridakis, 2002).

Insbesondere bei der Anwendung kleinster Probenvolumina ist darauf zu achten, dass die Lösung vor Ausdunstung geschützt sind, solange die Systeme nicht z.B. durch Applikation selbstklebender Folien oder durch Deckel, d.h. mechanisch, verschlossen sind.

Eine Vielzahl von verschiedenen Vorrichtungen für die Kristallisation von biologischen Makromolekülen existieren. So beschreibt z.B. das US-Patent 5,096,676 eine Vorrichtung für die Kristallisation im sitzenden Tropfen, die z.B. mittels einer selbstklebenden Folie verschlossen werden kann. Weitere Vorrichtungen werden in den US-Patenten 5,130,105; 5,221,410; 5,400,741; 5,419,278; 6,039,804, sowie in den Anmeldungen US-2002/0141905; US-2003/0010278, WO/00/60345, WO/01/88231 und WO/02/102503 beschrieben.

Sämtliche Vorrichtungen erlauben klassische vapor-diffusion Kristallisationsexperimente und müssen mechanisch verschlossen werden, z.B. mittels einer selbstklebenden Folie.

Bei automatisierten Batch-Verfahren werden von Robotern die in den entsprechenden Screening-Ansätzen verwendeten Lösungen z.B. unter Paraffinöl deponiert (Chayen, N. E. and Blow D. M.; J. Crystal Growth. 1992, 122, 176-80). Die wässrige Lösung ist somit direkt vor Ausdunstung geschützt. Dies ist insbesondere bei der Verwendung von kleinsten Probenvolumina wichtig, da durch geringste Wasserverluste die eingestellten Konzentrationen erheblich variieren können und somit die Reproduzierbarkeit beeinflussen (Störeinflüsse). Solche automatisierten Verfahren sind mit den üblichen Nachteilen von Batchverfahren verbunden, da keine Konzentrationsänderung und im Falle einer Konzentrationsänderung kein Endpunkt einstellbar ist. Die Anwendung adaptiver, auf statistischer Analyse beruhender Kristallisationsverfahren setzten jedoch eine genaue Kenntnis der Endkonzentration voraus.

Die DE-A-3009763 betrifft flüssige kosmetische Mittel mit einem Gehalt an üblichen kosmetischen Bestandteilen, das dadurch gekennzeichnet ist, dass es aus drei flüssigen Phasen, sowie gegebenenfalls einer zusätzlichen festen Phase besteht, wobei die Flüssigkeiten dieser drei Phasen nicht miteinander mischbar sind.

Die US-A-5,011,663 offenbart Teströhrchen für die klinisch-chemische Analyse, die aus einer Vielzahl von Zellen bestehen, wobei jede der Zellen einen unteren Bereich umfasst für das Sammeln eines Reagenz und einen intermediären Bereich zur Lagerung der zu testenden Substanz nach Mischung mit dem Reagenz. Die Zellen sind miteinander verbunden und in einer geraden Linie konfiguriert.

Der Erfindung liegt das Problem zugrunde, ein Kristallisationsverfahren bereitzustellen, dass die benannten Nachteile der Verfahren nach dem Stand der Technik überwindet. Insbesondere soll ermöglicht werden, mit relativ wenig Aufwand und relativ hoher Erfolgswahrscheinlichkeit möglichst homogene und große Kristalle von Makromolekülen zu erhalten.

Das erfindungsgemäße Verfahren soll auch als automatisiertes Verfahren zum Screening von Kristallisationsansätzen geeignet sein. Insbesondere soll das automatisierte erfindungsgemäße Verfahren für Roboter einfach und mit relativ wenigen Arbeitsschritten durchführbar sein und die beschriebenen Nachteile automatisierter Kristallisationsverfahren überwinden.

Das der Erfindung zugrundeliegende Problem wird überraschenderweise gelöst durch ein Verfahren zur Kristallisation von Makromoiekülen gemäß Ansprüch 1 bis 12.

Gegenstand der Erfindung ist auch eine Vorrichtung nach einem der Ansprüche 13 bis 16.

Der Erfindung liegt die Bereitstellung und Verwendung eines Dreiphasensystems zugrunde. Die wässrige Lösung der Makromoleküle bildet dabei eine vierte Phase, die sich nicht unmittelbar mit der unteren Phase vermischt. Im allgemeinen wird die vierte Phase in einer Menge. zugegeben, dass sie einen Tropfen bildet. Vorzugsweise wandert die vierte Phase nach Einbringen in das Gefäß zur Phasengrenze zwischen der unteren und mittleren Phase. Eine Vermischung mit der unteren Phase, die ja ebenfalls eine wässrige Phase ist, findet nicht statt. Vielmehr verbleibt die vierte Phase mindestens so lange im System, bis der Knstallisationsprozess einsetzt. In alternativen Ausführungsformen positioniert sich die vierte Phase an der Phasengrenze der mittleren und oberen Phase oder innerhalb der mittleren Phase. Wichtig ist, das keine unmittelbare Vermischung mit der unteren wässrigen Phase stattfindet. Der Begriff "vierte Phase" bezeichnet allgemein die wässrige Lösung des Makromoleküls, auch wenn das Dreiphasensystem aus unterer, oberer und mittlerer Phase noch nicht vollständig ausgebildet ist.

### Kurzbeschreibung der Figuren

Figur 1 beschreibt physikalisch-chemische Zusammenhänge in einem Phasendiagramm.
Figur 2 zeigt den schematischen Aufbau eines Dreiphasensystems.
Figur 3 zeigt eine Photographie für drei Dreiphasensystemen.
Figur 4 zeigt in Vergrößerung eine Lösung eines Makromoleküls.
Figur 5 zeigt in Großaufnahme Kristalle, die gemäss der Anordnung in Figur 4 erhalten wurden.
Figur 6 zeigt eine spezielle Ausführungsform.
Figur 7 zeigt ein Photo des erfindungsgemäßen Systems, bei dem drei Ausbuchtungen an einem Reservoir angeordnet sind.
Figur 8 zeigt einen Vergleich verschiedener Bedingungen am Beispiel der Glucose Isomerase und der Xylanase.
Figur 9 zeigt einen erfindungsgemäßen Probenträger.
Figur 10 zeigt einen vertikalen Schnitt durch den erfindungsgemäßen Probenträger.
Figur 11 zeigt eine Ausführungsform des erfindungsgemäßen Probenträgers.
Figur 12 zeigt schematisch eine Seitenansicht eines vertikalen Schnittes durch den Probenträger nach Figur 11.
Figur 13 zeigt eine Probenposition in dem erfindungsgemäßen Probenträger.
Figur 14 zeigt schematisch eine Seitenansicht eines diagonalen Schnittes durch den Probenträger gemäss Figur 13.

### Detaillierte Beschreibung der Erfindung

Figur 1 zeigt vereinfacht und schematisch das unterschiedliche Verhalten der gängigen Kristallisationsverfahren in einem Phasendiagramm. L, M und U bezeichnen jeweilig die lösliche, metastabile und unstabile Region des Phasendiagramms.

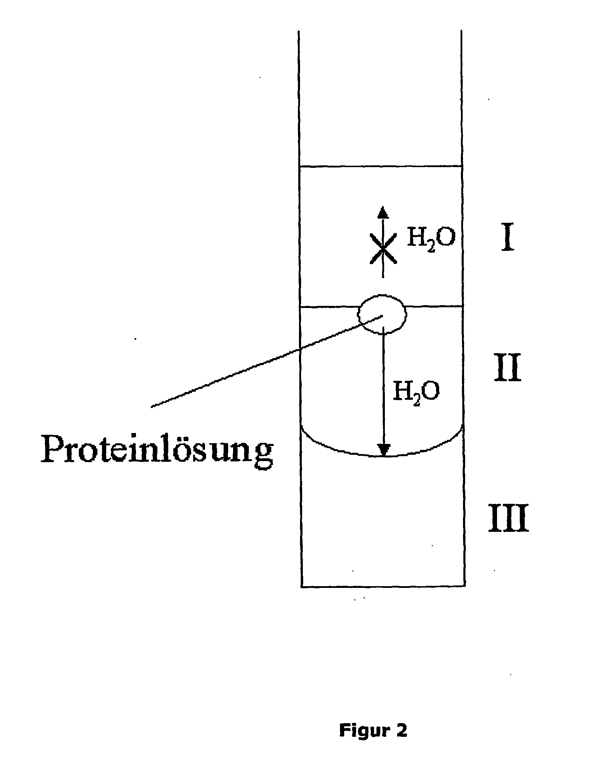

Figur 2 zeigt den schematischen Aufbau eines erfindungsgemäßen Dreiphasensystems mit einer tropfenförmigen vierten Phase, die an der Phasengrenze zwischen der oberen und mittleren Phase lokalisiert ist. Erfindungsgemäß findet eine Diffusion von Wasser nach oben im wesentlichen nicht statt. I, II und III entsprechen der oberen, mittleren und unteren Phase.

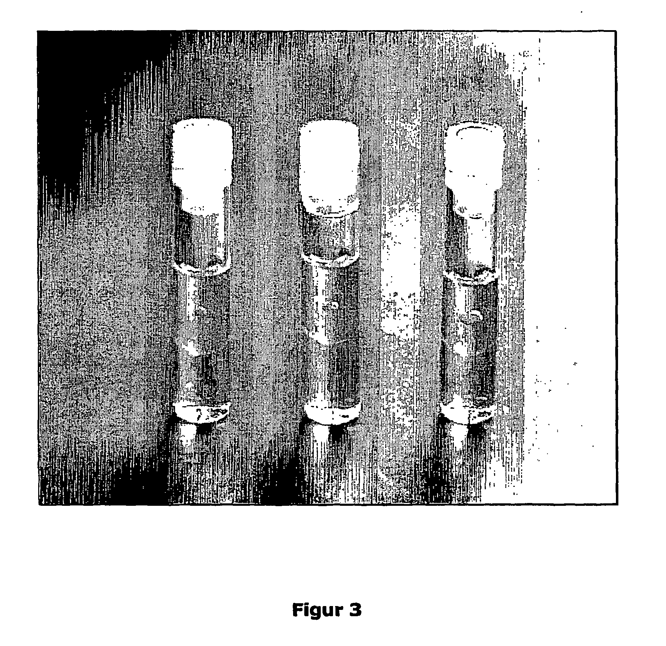

Figur 3 zeigt eine Photographie von drei erfindungsgemäßen Dreiphasensystemen, bei denen jeweils die Lösung des Makromoleküls tropfenförmig zwischen der oberen und mittleren Phase lokalisiert ist.

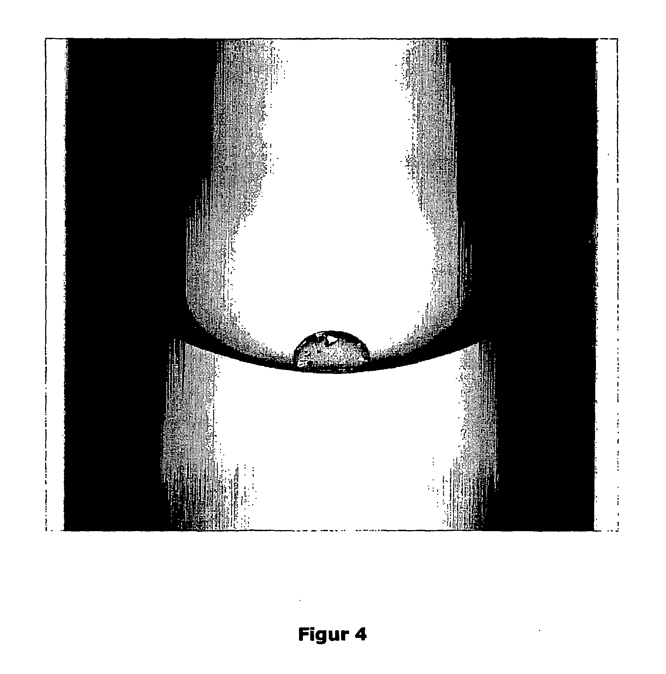

Figur 4 zeigt in Großaufnahme eine Lösung des Makromoleküls, die sich an der Phasengrenze zwischen der mittleren und unteren Phase positioniert hat.

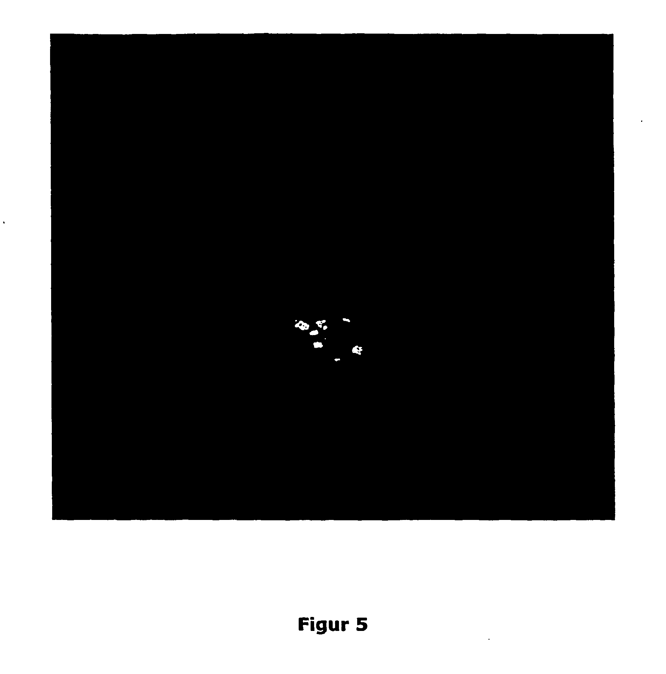

Figur 5 zeigt für den selben Ansatz wie Figur 4 in Großaufnahme die Kristalle, die sich in einem erfindungsgemäßen Dreiphasensystem gebildet haben. Die Lysozymkristalle sind mit polarisiertem Licht und mit einem um 90° versetzten Analysator detektierbar.

Die Phasen des Kristallisationssystems werden schematisch anhand von Figur 2 und photographisch durch Figur 3 verdeutlicht. In Figur 3 ist eine vierte tropfenförmige Phase zwischen den Phasengrenzen der mittleren und oberen Phasen positioniert. Die Phasengrenze ist in Figur 3 nicht deutlich zu erkennen, jedoch zeigt Figur 4 eine Großaufnahme einer vierten Phase an der Phasengrenze der mittleren und unteren Phase. In diesem metastabilen Zustand verbleibt die vierte Phase über einen längeren Zeitraum und dringt nicht in die untere wässrige Phase ein.

Die vierte Phase vermischt sich solange nicht vollständig mit der unteren Phase, bis die Kristallisation in der vierten Phase oder an einer Phasengrenze zur vierten Phase einsetzt. Vorzugsweise ist die vierte Phase für mindestens 6, 12 oder 24 Stunden unterscheidbar, besonders bevorzugt für mindestens 2, 4, 6, 14, 21 oder 30 Tage.

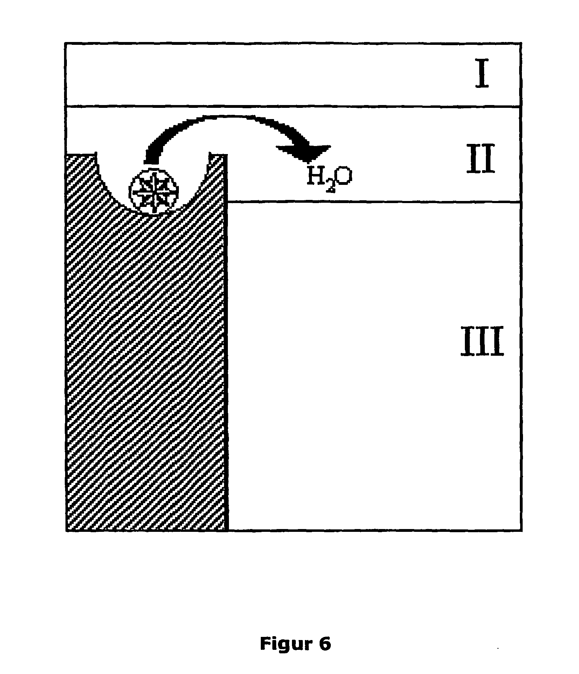

In einer bevorzugten Ausführungsform ist das verwendete Gefäß so ausgestaltet, dass die vierte Phase nicht in Kontakt mit der unteren Phase kommen kann. Die vierte Phase ist dann mechanisch stabilisiert. Dabei ist die vierte Phase vorzugsweise in einem Teilbereich lokalisiert, der vom übrigen Probengefäß durch seitliche Wände abgetrennt ist. Die vierte Phase ist somit in einer Ausbuchtung oder Ausgrenzung lokalisiert. Figur 6 zeigt schematisch, wie eine solche Ausführungsform erfindungsgemäß realisiert werden kann. In dieser Ausführungsform ist die Lösung des Makromoleküls durch eine Ausbuchtung im Gefäß daran gehindert, sich weiter zu der unteren Phase hin zu bewegen. Die Diffusion von H₂O erfolgt in Pfeilrichtung. I, II und III entsprechen der oberen, mittleren und unteren Phase.

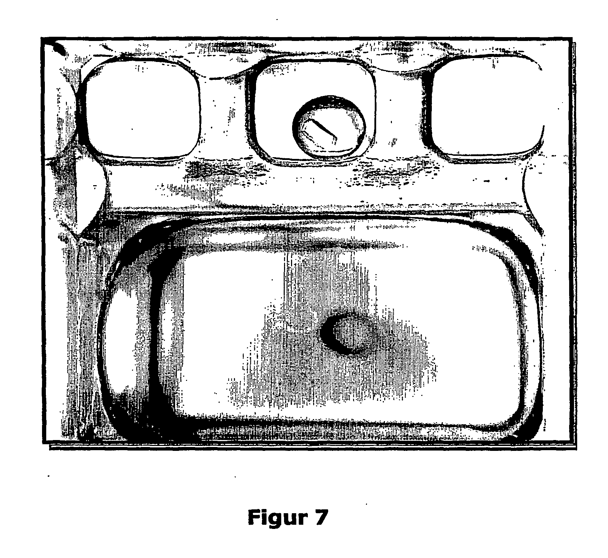

Der Tropfen kann aufgrund einer physischen Barriere nicht in die untere Phase gelangen. Erfindungsgemäß ist es möglich, in einem Dreiphasensystem mehr als eine Makromoleküllösung als getrennte Phase zur Kristallisation zu bringen. Figur 7 zeigt eine erfindungsgemäße Ausgestaltung des Gefäßes mit drei Vertiefungen. Dargestellt ist ein Photo von oben auf ein erfindungsgemäßes System, bei dem drei Ausbuchtungen gemeinsam an einem Reservoir angeordnet sind. In der mittleren Ausbuchtung sind deutlich sichtbare Kristalle entstanden. Die Ausbuchtungen sind mit dem Reservoir über eine durchgängige mittlere Phase verbunden,- durch die H₂O zum Reservoir diffundieren kann. In der mittleren Vertiefung liegt eine räumlich von der unteren Phase getrennte vierte Phase vor. Derartige Ausgestaltungen sind erfindungsgemäß auch als Multiwellplatten realisierbar, die die gleichzeitige oder sequentielle Untersuchung einer Vielzahl von Proben erlauben.

In einer weiteren Ausführungsform kann die untere wässrige Phase auch durch eine Phase mit hygroskopischen, in Bezug auf die Lösung des Makromoleküls wasseranziehenden Eigenschaften ersetzt/komplementiert werden. Die hygroskopische Substanz kann fester und/oder flüssiger Natur sein. Im Gegensatz zu Batchverfahren findet durch den Wasserentzug eine Konzentrationsänderung im System statt, die ebenfalls je nach Wahl der Natur und Quantität der hygroskopischen Substanz mit einem Endpunkt einhergeht.

In einer bevorzugten Ausführungsform wird ein Dreiphasensystem vor Zugabe der vierten Phase erstellt. In einer weiteren Ausführungsform wird die vierte Phase in den Teilbereichen, die vom übrigen Probengefäß abgetrennt sind, zuerst vorgelegt und anschließend das Dreiphasensystem erstellt. In einem Screeningtest wird dann die Proteinlösung der wässrigen vierten Phase in einen Teilbereich zugegeben und kann durch Entzug von H₂O mit der unteren Phase wieder ins Gleichgewicht kommen. In einer weiteren Ausführungsform kann die obere Phase über die Ränder der Probengefäße hinaus appliziert werden, wonach die untere Phase in jedes Probengefäß appliziert wird. Das System ist somit von Anfang an vor Ausdunstung geschützt. Von der unteren Phase kann dann ein Tropfen aufgenommen und in die abgetrennten Teilbereiche appliziert werden. Die Proteinlösung kann dann zu dem Tropfen in dem abgetrennten Teilbereich appliziert werden, gefolgt von der zweiten Phase, die in jedes Probengefäß gegeben wird, ohne jedoch über den Rand der einzelnen Probengefäße zu führen.

In einer bevorzugten Ausführungsform befinden sich die Ausbuchtungen oder Ausgrenzungen und/oder deren Seitenwand oder Seitenwände auf verschiedenen Höhen-Niveaus, wodurch je nach der applizierten Menge der zweiten Phase nur eine oder aber auch mehrere Ausbuchtungen oder Ausgrenzungen sich über die zweite Phase mit der unteren Phase, der Reservoirlösung, ausgleichen können. Die Ausbuchtungen oder Ausgrenzungen, die mit der unteren Phase kommunizieren, verhalten sich wie klassische vapour-diffusion Methoden. Die Ausbuchtungen, die sich nicht mit der Reservoirlösung ausgleichen, verhalten sich wie klassische Mikrobatch - Methoden, da sie z.B. von Paraffinöl umgeben sind. Somit ist es möglich, in nur einem Arbeitsaufwand in einer Probenposition eines Probenträger sowohl einen klassichen Ansatz als auch einen Mikrobatch-Ansatz zu realisieren.

Aus den hier gezeigten Vorgehensweisen wird ersichtlich, dass der Aufbau der Kristallisationsexperimente in einer Vielzahl von Varianten realisiert werden kann.

Durch die obere Phase findet über die Dauer des Kristallisationsvorgangs im wesentlichen keine Diffusion von H₂O aus dem Gefäß statt. In einer bevorzugten Ausführungsform enthält die obere Phase Paraffinöl. Es kann aber jedes andere Öl oder jede andere Flüssigkeit verwendet werden, die in der Lage ist, als obere Phase die Ausdünstung von Wasser aus dem System einzuschränken. In einer weiteren Ausführungsform ist die oberste Phase eine Folie oder ein Deckel, die in der Lage sind die Ausdünstung von Wasser aus dem System einzuschränken.

Die mittlere Phase wird so ausgewählt, dass eine Diffusion von H₂O von der vierten Phase in die unterste Phase stattfindet. Daher nimmt die Konzentration des Makromoleküls in der vierten Phase kontinuierlich zu. Da das Gesamtsystem im wesentlichen kein Wasser verliert, kann durch die Auswahl der Zusammensetzung der wässrigen unteren Phase ein Endpunkt für die Kristallisation eingestellt werden, bei dem die untere und die vierte Phase sich im Gleichgewicht befinden.

Die mittlere Phase kann auch aus komplexen Gemischen, z.B. verschiedener Viskositäten und/oder chemischer Natur bestehen. Des weiteren darf die mittlere Phase die diffusionshemmenden Eigenschaften der oberen Phase nicht unverhältnismäßig mindern.

Die mittlere Phase enthält in bevorzugten Ausführungsformen Hydroxy-terminiertes Poly-Dimethylsiloxan und/oder Phenylmethyl-Polysiloxane, insbesondere Phenylmethyl-Dimethyl-Polysiloxane. Bei der Wahl der Flüssigkeit für die mittlere Phase spielt insbesondere deren Viskosität sowie im Falle des Phenylmethylsilikonöls das Verhältnis der Methyl- zu den Phenylgruppen eine Rolle.

Die untere wässrige Phase enthält vorzugsweise Salze, Puffersubstanzen, Polymere und/oder organische Lösungsmittel.

Die wässrige Lösung des Makromoleküls enthält in bevorzugten Ausführungsformen Salze, Puffersubstanzen, Polymere und/oder organische Lösungsmittel.

In einer bevorzugten Ausführungsform enthält die wässrige Lösung des Makromoleküls abgesehen vom Makromolekül selbst die gleichen Bestandteile wie die untere wässrige Phase, jedoch in geringerer Konzentration.

In einer bevorzugten Ausführungsform wird die wässrige Lösung des Makromoleküls durch die Kombination eines bestimmten Volumens der unteren Phase mit einem bestimmten Volumen der wässrigen Lösung des Makromoleküls erstellt.

In einer bevorzugten Ausführungsform hat die vierte Phase ein Volumen zwischen 1 pl und 10 µl, bevorzugt 100 pl bis 2 µl, weiter bevorzugt zwischen 10 und 500 nl.

Die Makromoleküle der vierten Phase, die erfindungsgemäß kristallisiert werden, sind in bevorzugten Ausführungsformen Proteine, DNA, RNA, Komplexe von Makromolekülen, Proteinkomplexe, Protein/Ligandenkomplexe, DNA/Ligandenkomplexe, Protein/RNA-Komplexe, Protein/DNA-Komplexe, Viren oder Virenfragmente. Allgemein können erfindungsgemäß Makromoleküle, sowie sonstige größere Moleküle, biologischen oder synthetischen Ursprungs, kristallisiert werden.

Die Erfindung offenbart auch Kristalle von Makromolekülen, die nach dem erfindungsgemäßen Verfahren erzeugt werden. Das Verfahren der Erfindung ist auch ein Herstellungsverfahren für Kristalle von Makromolekülen.

Die Erfindung offenbart auch Strukturen von Makromolekülen, die bei der Untersuchung von Kristallen, die durch das erfindungsgemäße Verfahren erzeugt wurden, ermittelt werden.

Beschrieben wird auch ein Dreiphasensystem zur Kristallisation von Makromolekülen, bei dem in einem Gefäß drei Phasen übereinander vorliegen, wobei diese eine untere wässrige Phase, eine mittlere Phase und eine obere hydrophobe Phase mit geringerer Dichte als die untere wässrige Phase sind. Denkbar sind auch Gefäße, bei denen die Phasen nebeneinander liegen, z.B. in Mikrofluidiksystemen. Die drei Phasen sind vorzugsweise flüssig. Es sind jedoch auch andere Ausführungsformen durchführbar. So kann die untere Phase beispielsweise gelartig oder fest sein. Das erfindungsgemäße Dreiphasensystem (mit oder ohne vierte Phase) kann auf alle möglichen Weisen etabliert werden. So kann zum Beispiel die untere wässrige Phase zuerst vorgelegt werden, oder später unterschichtet werden. Wesentlich ist nur, dass ein im wesentlichen stabiles System zur Kristallisation erhalten wird, bei dem die Phasen möglichst sauber voneinander getrennt sind.

Das erfindungsgemäße Verfahren ermöglicht den Erhalt von relativ gleichmäßigen und großen Kristallen. Das Verfahren ist einfach, schnell durchführbar und in hohem Masse reproduzierbar, wobei das Problem der Verdunstung auch bei Verwendung geringer Proteinmengen nicht gegeben ist. Je nach Ausführungsform bestehen keine oder nur geringe Wandkontakte mit dem Probenträger, was zu einer geringeren Nukleationsrate und somit zu größeren Kristallen führt. Die Proteintropfen besitzen eine homogene Form und weisen im Vergleich zu klassischen Verfahren weniger Störeffekte auf, was Verfahren der Bildaufnahme- und Bildbewertung vereinfacht. Durch die Präsenz der zweiten Phase wird die oft bei klassichen Verfahren entstehende Haut vermieden, welche den Tropfen umgibt, was eine leichtere Handhabung und Isolierung der Kristalle ermöglicht. Durch die Wahl der mittleren Phase steht ein zusätzlicher Parameter bezüglich der Dynamik der Einstellung des Endpunktes zur Verfügung, der die Nukleationsrate mitbestimmt.

Je nach Ausführungsform kann das System nach der Beobachtung eines Nukleationsereignisses aus dem übersättigten Zustand geführt werden, indem der unteren Phase als Reservoirlösung zum Beispiel eine bestimmten Wassermenge zugegeben wird. Dies kann insbesondere die Ausbildung weiterer Nukleationskeime unterbinden und somit zu größeren Proteinkristallen führen. Nachdem das Kristallwachstum des/der initialen Kristallisationskeim(e) sich durch Erreichen des Gleichgewichtszustandes verlangsamt, kann unter Zugaben eines Konzentrates der Ausfällungsreagenz oder einer hygroskopischen Substanz in die Reservoirlösung das Kristallwachstum graduell wieder initiert und weiter gefördert werden, ohne eine erneute Nukleation zu initieren. Dies führt zu Einkristallen substantieller Größe. Im Gegensatz zu beschriebenen Methoden (Chayen, N. E.; J. Crystal Growth. 1999, 196, 434-41), ist durch die flüssige Natur der Phasen das umständliche Öffnen von geschlossenen Systemen nicht mehr vonnöten. Desweitern kann in einer Ausführungsform die hier beschriebene Kristallzucht unter Inanspruchnahme eines kontinuierlichen Monitoring, realisiert werden, welches neben der Charakterisierung der Lösungsparameter, wie z.B. der Bestimmung des zweiten Virialkoeffizienten, auch die Detektion von Nukleatioriskeimen zur Aufgabe hat. Insbesondere Verfahren der dynamischen Lichtstreuung eignen sich neben den klassischen Bildanalyseverfahren zur Detektion von Nukleationsereignissen, da diese bereits sehr früh Nukleationskeime detektieren können (Rosenberger, F.; Vekilov, P. G.; Muschol, M.; Thomas, B. R.; Journal of Crystal Growth, 1996, 168, 1-27; Saridakis, E.; Dierks, K.; Moreno, A.; Dieckmann, M. W.; Chayen, N. E.; Acta Crystallographica, 2002, D58, 1597-1600; Spraggon, G.; Lesley, S. A.; Kreusch, A.; Priestle, J. P.; Acta Crystallographica, 2002, D58, 1915-1923).

Der Diffusionsprozess kann des weiteren durch Abpipettieren der mittleren Phase gestoppt werden, indem eine ausreichende Menge der mittleren Phase entnommen wird und die flüssige Verbindung zwischen dem Tropfen, welcher die vierte Phase bildet und der unteren Phase im Reservoir abreißt. In einer bevorzugten Ausführungsform können initiale Lösungsparameter bestimmt werden, und anschließend der Diffusionsprozess durch Zugabe der mittleren Phase unter die obere Phase initiiert werden.

Insbesondere die Bestimmung initialer Lösungsparameter, wie z.B des zweiten Virialkoeffizienten müssen so realisiert werden, dass keine Konzentrationsänderung die Lösungsparameter beeinflußt. Der zweite Virialkoeffizient ermöglicht Rückschlüsse auf die intermolekulare Wechselwirkungen zwischen Makromolekülen, was die Grundlage der Nichtidealität einer Lösung hinsichtlich ihres osmotischen Druckes ist. Ein positiver Virialkoeffizient verweist auf repulsive, ein negativer Virialkoeffizient auf attraktive Wechselwirkungen. Dabei ist bekannt, dass ein leicht negativer Virialkoeffizient oft die Kristalisation fördert, ein stark negativer Wert jedoch zu einer weniger geordneten Ausfällung führt (George, A.; Wilson, W. W.; Acta Crystallographica, 1994, D50, 361-365; George, A.; Chiang, Y.; Guo, B.; Arabshahi, A.; Cai, Z. Wilson, W. W.; Methods in Enzymology, 1997, 276, 100-110). Da für die Bestimmung des zweiten Virialkoeffizienten eine statische Laserstreulichtmessung über eine Konzentrationsreihe des Makromoleküls bei definierten Lösungsparametern realisiert wird, wie z.B. einer konstanten Salzkonzentration und einem konstantem pH, ist es wichtig, dass die Lösungsparameter zwischen mehreren Messungen konstant bleiben und nicht durch eine Diffusion von Wassermolekülen zu der Reservoirlösung beeinflusst werden. Dies ist im initialen Batchmodus des neuen Verfahrens möglich, wonach der Diffusionsprozess erst nach Abschluß sämtlicher Messungen innerhalb eines Probenarrays durch Zugabe der zweiten Phase initiert wird.

Es wird insbesondere auch die Verwendung des erfindungsgemäßen Verfahrens, der Vorrichtung und/oder des Dreiphasensystems zur automatisierten Kristallisation oder zum automatisierten Screening offenbart. Das erfindungsgemäße Verfahren ist in hohem Masse geeignet für die Verwendung im Rahmen automatisierter, Robotergestützter Verfahren. Es sind im Vergleich zu den klassischen Methoden deutlich weniger Arbeitsschritte nötig. Der Roboter muss lediglich die Lösungen nacheinander pipettieren. In einer bevorzugten Anwendungsform sind die Lösungen bereits vorpipettiert und die Lösung des Makromoleküls muß lediglich zugefügt werden. Die Applikation von Glasdeckeln, das Drehen der Deckel, oder die Versiegelung des Systems mit Folie oder ähnlichem sind nicht mehr erforderlich. Trotzdem geht die Kristallisation mit einem dynamisch einstellbaren Endpunkt einher.

Gegenstand der Erfindung ist auch eine Vorrichtung zur Kristallisation von Makromolekülen, bei der eine Vielzahl von Probengefäßen zu einem Probenträger angeordnet sind, wobei der Probenträger einen durchgängigen Rand aufweist, der höher angeordnet ist als die Öffnungen der Probengefäße. Innerhalb der Probengefäße liegt die untere wässrige Phase vor, die von der mittleren Phase überschichtet ist. Da der Probenträger einen erhöhten Rand aufweist, können alle Probengefäße zugleich in einem einzigen Arbeitsschritt mit der oberen Phase überschichtet werden. Die obere Phase schließt dabei jedes Probengefäß nach oben hin ab und bildet darüber eine einzige verbundene Phase, die den gesamten Probenträger durchzieht. Auf diese Weise ist es nicht mehr erforderlich, in jedes einzelne Probengefäß die obere Phase zu applizieren. In einer Ausführungsform können auch zwei oder mehrere Probengefäße über die zweite Phase miteinander kommunizieren, indem z.B. eine Kerbe in die seitliche Abgrenzung zweier oder mehrerer Probengefäße realisiert wird. Wird bei dieser Ausführungsform nur in ein Probengefäß die untere Phase appliziert und die untere Phase in den anderen Probengefäßen z.B. durch die mittlere Phase ersetzt, kann je nach Distanz zum Probengefäß mit der unteren Phase die Dynamik der Endpunktbestimmung beeinflusst werden und somit die Nukleationsrate. Dies ermöglicht ein Screening des Einflusses der Dynamik der Endpunktbestimmung auf die Güte der Protein-Einkristalle.

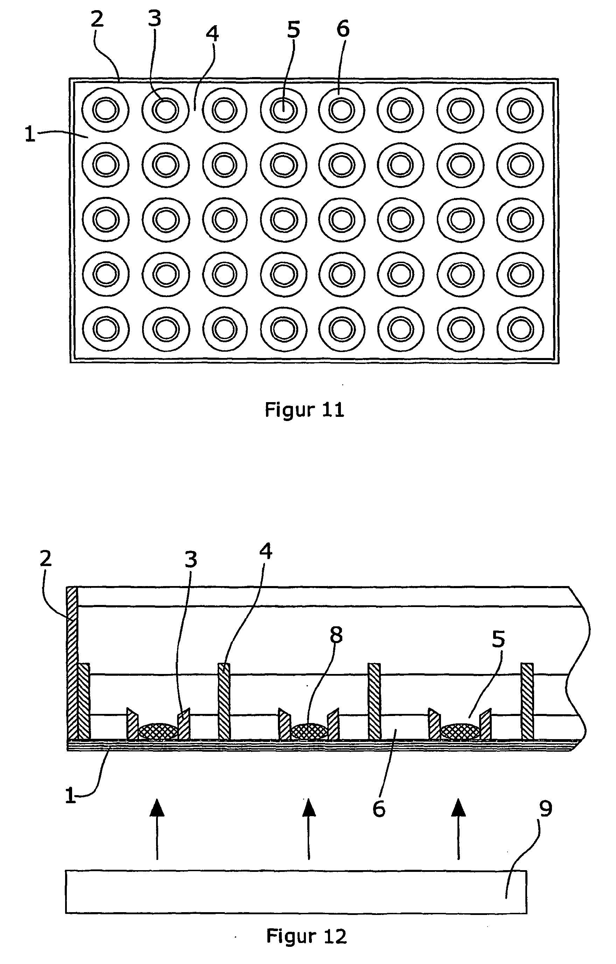

In jedem Probengefäß ist ein Teilbereich (Ausbuchtung) vorhanden, der von dem übrigen Teil des Probengefäßes durch seitliche Wände abgetrennt ist, wobei die seitlichen Wände niedriger sind als die seitlichen Wände des Probengefäßes. Solche Ausführungsformen sind in den Figuren 11 bis 14 dargestellt.

Figur 11 zeigt einen erfindungsgemäßen Probenträger (1) mit Probengefäßen (6), seitlichen Wänden der Probengefäße (4) und einem erhöhten Rand (2). In den Probengefäßen (6) sind Teilbereiche (5) vorhanden, die von dem übrigen Teil des Probengefäßes durch seitliche Wände (3) abgetrennt sind.

Ein solcher Probenträger kann leicht realisiert werden, indem zuerst ein Korpus eines Probenträgers z.B. durch bekannte Spritzguss-Verfahren realisiert wird, der bis auf die Glasplatte sämtliche Teile des Probenträgers enthält. Dabei sollten die niedrigen internen Ausbuchtungen innerhalb eines jeden Probenträgers über kleine Stege gehalten werden, die so ausgelegt sind, dass sie ein Befüllen der äußeren Ausgrenzung durch eine einmalige Applikation der oberen Phase ermöglichen. Dem Fachmann ist dabei bekannt, wie bei der Ausgestaltung des Probenträgers dessen Formstabilität im Produktionsprozess gewahrt wird. Der fertige Probenträger wird dann durch Aufkleben der Glasplatte auf den Boden des Korpus erhalten. Um eine hydrophile Interaktion mit der vierten Phase zu unterdrücken, kann die Glasplatte durch bekannte Verfahren der Oberflächenbehandlung, wie z.B. einer Silikonisierung oder Silanisierung, modifiziert werden.

Figur 12 zeigt schematisch eine Seitenansicht eines vertikalen Schnittes durch einen Probenträger nach Figur 11. Die Merkmale 1 bis 6 sind verwirklicht wie bei Figur 11. In die abgetrennten Teilbereichen (5) der Probengefäße (6) wird die wässrige Phase des Makromoleküls (vierte Phase, 8) gegeben. Die Entwicklung von Kristallen wird mit einer Vorrichtung (9), z.B. einem Mikroskop, dass unterhalb des Probenträgers angeordnet ist, verfolgt. In Abweichung zur schematischen Darstellung ist die vierte Phase in der Regel als Tropfen kugelförmig (statt ellipsenförmig) ausgebildet und berührt nicht seitlich die Gefäßwände.

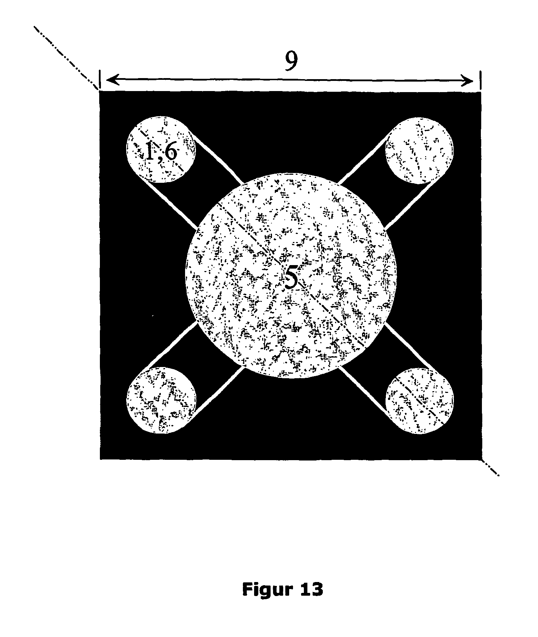

Figur 13 zeigt eine Probenposition eines erfindungsgemäßen Probenträgers. Je Probenposition können bis zu vier Kristallisationsexperimente realisiert werden. Im Zentrum der Probenposition befindet sich die Ausgrenzung für eine Reservoirlösung. Durch die zentrale Lage sowie die Größe des Reservoirs kann dieses leicht zum Anmischen der komplexen Ausfällungsreagenzien verwendet werden. Die vier Ausgrenzungen für die vierten Phasen sind mit der Reservoirzone über eine Vertiefung im Korpus des Probenträgers verbunden. Der Boden des Probenträgers besteht aus Kunststoff oder Glas. Im Falle von Kunststoff kann der Korpus des Probenträgers durch Bohrungen realisiert werden. Die Verbindung zwischen der zentralen Position für die Ausfällungsreagenz und den Ausgrenzungen kann durch Ausfräsen eines Steges zwischen den Positionen realisiert werden. Die Dimensionen sind in Millimeter angegeben und dienen lediglich als Beispielwerte.

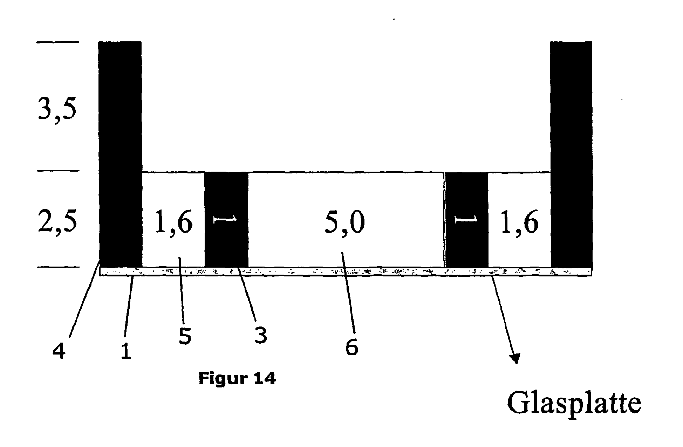

Figur 14 zeigt schematisch eine Seitenansicht eines diagonalen Schittes durch eine Probenposition des erfindungsgemäßen Probenträgers gemäß Figur 13.

Die Seitenwände der Teilbereiche bilden in den Figuren 11 und 12 einen Ring, so dass die Teilbereiche kreisförmig in der Mitte der Probengefäße liegen. In den äußeren Teil der Probengefäße wird die untere Phase gegeben bis zu einer Höhe, die unterhalb der Höhe der Seitenwände des Teilbereichs liegt, gefolgt von einem Tropfen in den/die Teilbereiche. In die Teilbereiche wird vor oder nach Aufbau des Dreiphasensystems die wässrige Lösung des Makromoleküls (die vierte Phase) gegeben. Die mittlere Phase wird so appliziert, dass die Teilbereiche mit der mittleren Phase gefüllt werden und die ringförmige Seitenwand der Teilbereiche mit der mittleren Phase überschichtet ist. Wassermoleküle können so von der vierten Phase durch die mittlere Phase in die untere Phase des Dreiphasensystems diffundieren.

In einer bevorzugten Ausführungsform sind die Oberkanten der Seitenwände der Teilbereiche mit einer nach innen abfallenden Schräge ausgestaltet, so dass bei Applikation der vierten Phase diese in den Teilbereich gelenkt wird.

In einer weiteren Ausführungsform unterscheiden sich die Seitenwände der Ausbuchtungen oder Ausgrenzungen durch verschiedene Höhen.

In einer weiteren Ausführungsform (Figuren 13 und 14) liegen die Teilbereiche für die Proteinlösung um ein zentral gelegenes Reservoir für die untere Phase. Der Aufbau ermöglicht insbesondere in einem ersten Arbeitsschritt ein vereinfachtes Anmischen der Flüssigkeit für die untere Phase. Der Aufbau des Dreiphasensystems erfolgt dann wie beschrieben.

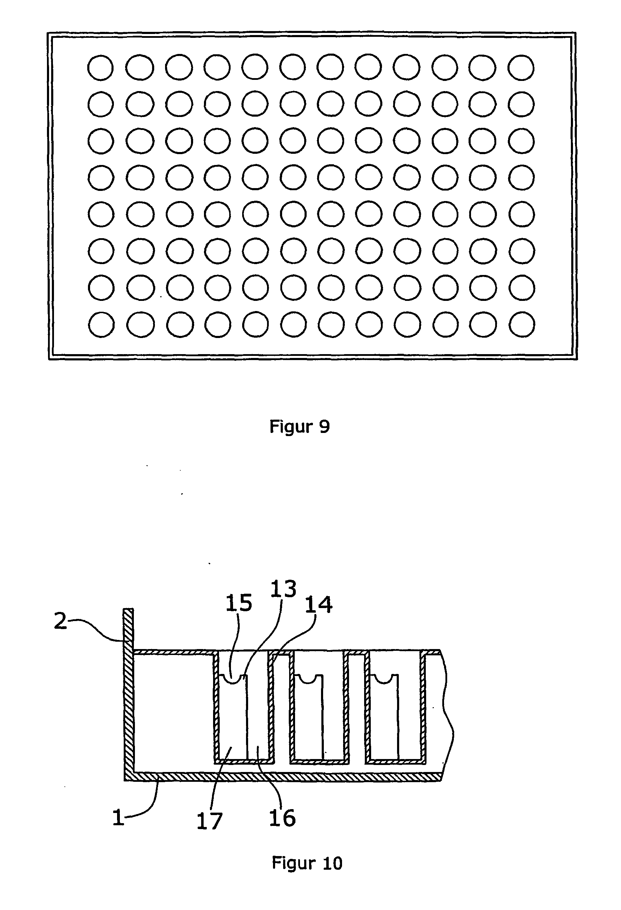

In einer weiteren Ausführungsform liegt der Boden (1) der Teilbereiche (5) auf derselben Höhe wie der Boden der Probengefäße (6). In einer weiteren Ausführungsform ist der Teilbereich gegenüber dem Boden des Probengefäßes erhöht. Der erhöhte Bereich liegt unterhalb der Öffnung des Probengefäßes. In einer weiteren bevorzugten Ausführungsform weisen die Probengefäße jeweils mindestens eine erhöhte Ausbuchtung auf. Diese Ausführungsformen der Erfindung werden durch Figur 10 verdeutlicht. Dort ist ein Teil eines vertikalen Schnitts durch einen erfindungsgemäßen Probenträger (1) mit Probengefäßen (16) gezeigt. Bei der gezeigten Ausführungsform sind in den einzelnen Probegefäßen (16), von denen drei in einer Reihe dargestellt sind, gegenüber dem Gefäßboden erhöhte Ausbuchtungen (15) vorhanden, in die oder über die die Lösung des Makromoleküls appliziert wird. Der Probenträger ist durch einen erhöhten Rand (2) gekennzeichnet, der es ermöglicht, die einzelnen Probengefäße mit der mittleren Phase zu befüllen und die mittleren Phasen mit einer durchgängigen oberen Phase zu überschichten. Dadurch wird der Vorgang der Bereitstellung eines erfindungsgemäßen Dreiphasensystems beträchtlich vereinfacht. Die Ausbuchtung (15) ist ein abgetrennter Teilbereich (15), der durch die seitlichen Wände (13) vom übrigen Probengefäß abgetrennt ist. Die seitlichen Wände (13) des Teilbereichs sind nach oben hin niedriger als die seitlichen Wände (14) der Probengefäße. Die Ausbuchtung ist auf einem Sockel (17) positioniert. Die Abmessungen und Relationen sind schematisch dargestellt. Für ein spezielles verwendetes Robotersystem wird ein Probenträger mit geeigneten Abmessungen ausgewählt.

In einer weiteren Ausführungsform ist der Teilbereich gegenüber dem Boden des Probengefäßes erhöht und der übrige Teil des Probengefäße, nicht aber der Teilbereich, unten teilweise oder vollständig offen, so dass alle unteren Phasen miteinander verbunden sind. Es muss dann nur ein einziges Mal eine untere Phase, eine mittlere Phase und eine obere Phase appliziert werden. Diese Ausführungsform findet Verwendung, wenn unterschiedliche Lösungen des Makromoleküls gegenüber einer einzigen definierten unteren Phase untersucht werden sollen. Diese Ausführungsform ist auch realisierbar, wenn in einem erfindungsgemäßen Probenträger mit erhöhtem Rand Probengefäße auf einer definierten Höhe unterhalb des erhöhten Randes positioniert werden, daß sie nur miteinander verbunden sind, sofern es die Stabilität des Probenträgers erfordert, z. B. durch ein Gitter. In diesen Probenträgern wird dann neben eines Tropfens der unteren Phase ein Tropfen der jeweilig zu testenden wässrigen Lösung (vierte Phase) appliziert.

Vorzugsweise ist der Boden des Probenträgers optisch homogen. Bevorzugt ist ein Glasboden.

So können neben mikroskopischen Aufnahmen auch weitere optische Messverfahren für die Charakterisierung der Lösungsparameter und/oder der biologischen Makromoleküle herangezogen werden, wie z.B. verschiedene Streulichtverfahren (z.B. elastische, quasielastische und/oder inelastische Lichtstreuung) zwecks Bestimmung von Konzentrationen, Größen, Größenverteilungen aber auch thermodynamische Parameter wie der zweiten Virialkoeffizienten und/oder hydrodynamische Parameter. Desweiteren können spektroskopische Methoden wie der Fluoreszenzanisotropie/Fluoreszenzdepolarisation unter Inanspruchnahme intrinsischer oder extrinsicher Fluorophore und/oder weiterer polarisationsspektroskopischer Verfahren zur Verfügung (Winter, R. und Noll, F.; Methoden der biophysikalischen Chemie, Teubner Studienbücher Chemie, Teubner Verlag, ISBN:3-519-03518-9). Dafür besitzen Tropfen, welche in dem hier vorgestellten Verfahren realisiert werden die positive Eigenschaft, dass sie mit einem Volumen von 1 µl in der Aufsicht annähernd den gleichen Durchmesser besitzen wie 200 nl große Tropfen in klassischen sitting-drop Experimenten. Die Tropfen des hier dargestellten Verfahrens besitzen somit, bedingt durch ihre kugelähnliche Topographie bessere Voraussetzungen für die Anwendung der oben erwähnten Verfahren, insbesondere unter Inanspruchnahme konfokaler Messgeometrien. Des weiteren bietet der Glasboden und die optisch homogene mittlere und obere Phase im Gegensatz zu Folienverschlossenen Systemen bessere Voraussetzungen für die Anwendung oben genannter Verfahren. Auf die Verwendung eines optisch homogenen Deckels kann verzichtet werden. Der Brechungsindex vieler hier verwendeter Flüssigkeiten der mittleren Phase liegt des weiteren im Bereich zwischen 1,4 und 1,5, was des weiteren einer Anwendung oben genannter Verfahren entgegenkommt.

Des weiteren können die erhaltenen Bildaufnahmen und sonstige Parameter in eine Datenbank abgelegt werden, um anschließend eine Analyse der Kristallisationsexperimente am Computer zu ermöglichen und/oder um bekannte Bildanalyseverfahren, wie z.B. eine Differential-Bildanalyse und/oder eine Kantendetektion anzuwenden. Auch bekannte Verfahren zur Bewertung von Niederschlagsmorphologien können eingesetzt werden sowie angepasste NMR und Ultraschall basierte Verfahren. Die Auswertung der verschiedenen Parameter der realisierten Kristallisationsexperimente lassen dann nach einer statistischen Auswertung eine systematisierte Ableitung neuer verbesserter Kristallisationsbedingungen zu. Des weiteren können mit Hilfe des Mikroskops Bildaufnahmen und sonstige Parameter in eine Datenbank abgelegt werden, um anschließend eine Analyse der Kristallisationsexperimente am Computer zu ermöglichen und/oder um bekannte Bildanalyseverfahren, wie z.B. eine Differential-Bildanalyse und/oder eine Kantendetektion anzuwenden.

Gegenstand der Erfindung ist auch eine Vorrichtung (1) zur Kristallisation von Makromolekülen, bei denen eine Vielzahl von Probengefäßen (6) zu einem Probenträger angeordnet sind, bei der in jedem Probengefäß (6) mindestens ein Teilbereich (5) vorhanden ist, der vom übrigen Probengefäß durch seitliche Wände (3) abgetrennt ist, wobei die seitlichen Wände (3) nach oben hin niedriger sind als die Wände des Probengefäßes (4), dadurch gekennzeichnet, dass der Boden des Probenträgers optisch homogen ist und das der Boden (1) der Teilbereiche (5) auf derselben Höhe liegt wie der Boden der Probengefäße (6). Bedingt durch die Topographie des Probenträgers kann bei dieser Ausführungsform auf einen die Vorrichtung umfassenden erhöhten Rand verzichtet werden. Der Probenträger ist auf einfache Art herstellbar und eignet sich des auch zur Durchführung klassischer Kristallisationsexperimente und stellt im Gegensatz zu bestehenden Probenträgern eine kostengünstige Variante mit einem optisch homogenen Boden dar. Der optisch homogene Boden bietet gegenüber den klassischen Hochdurchsatz-Probenträgern, die für Vapour-Diffusion Experimente verwendet werden den Vorteil, das die Detektion der Kristalle durch die Abwesenheit von Doppelbrechungseffekten der Polymere eine Detektion von Kristallen nicht-kubischer Symmetrie unter Inanspruchnahme polarisierten Lichtes stark vereinfacht.

Die erfindungsgemäße Vorrichtung eignet sich insbesondere für die Automatisierung unter Verwendung von Robotern. Es kann eine beliebige Anzahl von Probengefäßen auf einem Probenträger angeordnet werden (in Figur 9 sind 96 Proben angeordnet). Figur 9 zeigt die Aufsicht eines erfindungsgemäßen Probenträgers (1) zur automatisierten Durchführung des Kristallisationsverfahrens mit einem erhöhtem Rand (2), Probengefäßen (16) und Abschnitten zwischen den Probengefäßen (14).

Der Probenträger ist gekennzeichnet durch einen erhöhten Rand. Dadurch wird die robotergestützte Durchführung des Verfahrens stark vereinfacht: Es wird in jedes Probengefäß die untere wässrige Phase gegeben. Danach wird diese mit der mittleren Phase überschichtet, die vorzugsweise alle Probengefäße über die Höhe der Ausbuchtung hinaus, jedoch unter den Rand der einzelnen Probengefäße auffüllt. Danach erfolgt die Überschichtung des gesamten Systems mit der oberen Phase. Dadurch werden störende Miniskuseffekte an der Oberfläche unterbunden. Vorzugsweise ist die erfindungsgemäße Vorrichtung so ausgebildet, dass sie von gängigen Roboterformaten genutzt werden kann. Dies ist beispielsweise der Fall, wenn der Probenträger im Standard-96-Well Format 8 mal 12 Probengefäße aufweist, die jeweils 9 mm voneinander entfernt sind. Standards wie die der Society of Biomolecular Sciences (SBS; www.sbsonline.org) sind dem Fachmann bekannt.

Der Rand des Probenträgers ist ausreichend hoch, um die obere Phase aufzunehmen. Vorzugsweise ist der Anteil des erhöhten Randes an der Gesamthöhe des Probenträgers 2-50%, bevorzugt 5 bis 30%, besonders bevorzugt 10 bis 20%.

Bei der Automatisierung des Verfahrens können die einzelnen Probengefäße durch seitliche Wände abgetrennt Teilbereiche (Ausbuchtungen gemäß Figur 10 oder Ausgrenzungen gemäß Figuren 12 und 13) aufweisen. In einem Probengefäß können eine oder mehrere solche Teilbereiche vorhanden sein, z.B. drei Ausbuchtungen wie in Figur 7. Es können auch eine Vielzahl von Ausbuchtungen und/oder Ausgrenzungen neben einem Reservoir angeordnet sein.

Durch diese erfindungsgemäßen Ausführungsformen lassen sich eine Vielzahl von Arbeitsschritten einsparen, was die Verwendung als automatisierten Prozess stark erleichtert. Das Verfahren ist ähnlich einfach automatisiert durchführbar wie Batchverfahren nach dem Stand der Technik, ermöglicht jedoch eine dynamische Einstellung eines Endpunktes und eines metastabilen Zustandes. Des weiteren können zeitlich versetzte Testverfahren an mehreren Proteinen realisiert werden, wobei das Protein einer Ausbuchtung zugegeben wird, in die bereits vorher die wässrige Lösung (vierte Phase) vorgelegt wurde. Dies ermöglicht einen verringerten Verbrauch von Chemikalien und Probenträgern.

Bevor ein erfindungsgemäßes Dreiphasensystem etabliert wird, ist es nötig, die mittlere und die obere Phase so auszuwählen, dass saubere Phasengrenzen erhalten werden und dass die Reihenfolge der Phasen (unten/Mitte/oben) sich wie gewünscht, unter anderem durch Adhäsions- und Kohäsionskräfte, einstellt.

Die obere Phase muss eine geringere Dichte als die Lösung des Makromoleküls aufweisen und muss gegenüber H₂O diffusionshemmende Eigenschaften besitzen. Geeignet ist insbesondere Paraffinöl.

Zum Testen der mittleren Phase werden die einzelnen Flüssigkeiten für die mittlere Phase jeweils mit einer identischen Menge der oberen Phase überschichtet und anschließend bei Raumtemperatur inkubiert. Geeignete Flüssigkeiten bilden eine über einen längeren Zeitraum stabile Phasengrenze aus.

Um die Dampfdurchlässigkeit der mittleren Phase zu testen, wird die bekannte Kristallisation eines Makromoleküls in einem offenen System mit unterer wässriger Lösung des Makromoleküls und überschichteter mittlerer Phase untersucht (ohne obere Phase). Die verdünnte Lösung des Makromoleküls wird gefiltert, in ein Kristallisationsgefäß gegeben und mit der zu testenden mittleren Phase überdeckt. Anschließend wird der Ansatz über einen Zeitraum von mehreren Stunden bis mehreren Tagen beobachtet. Falls die mittlere Phase Wassermoleküle aus der Lösung des Makromoleküls ausdiffundieren lässt, entstehen je nach Diffusionsoffenheit und Schichtdicke Kristalle. Wenn die mittlere Phase die Diffusion von Wasser nicht zulässt und daher erfindungsgemäß nicht geeignet ist, bilden sich nach mehreren Tagen keine Kristalle.

Da die Lösung des Makromoleküls meist auf einer Elektrolytlösung basiert, muß außerdem das Verhalten der mittleren Phase in Bezug zur wässrigen Phase bewertet und sichergestellt werden, dass sich die für die mittlere Phase verwendete Flüssigkeit im wesentlichen nicht mit der wässrigen Phase vermischt und mit dieser kompatibel ist.

Um den Einfluss einer diffusionsoffenen mittleren Phase auf die diffusionshemmenden Eigenschaften der oberen Phase zu testen, wird zusätzlich mit einer Schicht von Paraffinöl beschichtet, die mindestens so dick sein sollte wie die Schicht der mittleren Phase. Wenn die mittlere Phase die diffusionshemmenden Eigenschaften der oberen Phase nicht substantiell beeinflusst, ist keine oder zumindest eine erheblich verzögerte Bildung von Proteinkristallen zu beobachten.

### Ausführungsbeispiele:

### Beispiel 1: Test der Löslichkeit der mittleren Phase in der oberen Phase

Es wird Paraffinöl (Paraffin dünnflüssig, Merck; Bestellnummer: 1.07174.1000) als obere Phase verwendet und nach einer kompatiblen mittleren Phase gesucht. Anstelle des Paraffinöls können andere Flüssigkeiten verwendet werden, die eine diffusionshemmende Eigenschaft und eine entsprechende Dichte aufweisen.

Tabelle 1 enthält exemplarisch eine Auflistung der getesteten Flüssigkeiten, die verschiedene Polysiloxane, Zufalls-Copolymere und ein Block-Copolymer umfasst.

**Tabelle 1:**

| | |
|---|---|
| I | Poly(dimethylsiloxan-Co-Methylphenylsiloxan), Trimethylsilyl-terminiert; Phenylmethylsiloxan-Anteil: ∼50% ; Viskosität bei 25°C: 100 mm²/s (Siiliconöl AP100, Wacker-Chemie GmbH) |
| II | Poly(dimethylsiloxan-Co-Methylphenylsiloxan), Trimethylsilyl-terminiert; Phenylmethylsiloxan-Anteil: ∼50 % ; Viskosität bei 25°C: 200 mm²/s (Siiliconöl AP200, Wacker-Chemie GmbH) |
| III | Poly(dimethylsiloxan-Co-Methylphenylsiloxan), Trimethylsilyl-terminiert; Phenylmethylsiloxan-Anteil: ∼50 % ; Viskosität bei 25°C: 500 mm²/s (siliconöl AP500, Wacker-Chemie GmbH) |
| IV | Poly(dimethylsiloxan-Co-Methylphenylsiloxan), Trimethylsilyl-terminiert; Phenylmethylsiloxan-Anteil: <50 % ; Viskosität bei 25°C: 20 mm²/s (Siliconöl AR20, Wacker-Chemie GmbH) |
| V | Poly(dimethylsiloxan-Co-Methylphenylsiloxan), Trimethylsilyl-terminiert; Phenylmethylsiloxan-Anteil: <50 % ; Viskosität bei 25°C: 200 mm²/s (Siiliconöl AR200, Wacker-Chemie GmbH) |
| VI | Poly(dimethylsiloxan-Co-Methylphenylsiloxan), Trimethylsilyl-terminiert; Phenylmethylsiloxan-Anteil: <50 % ; Viskosität bei 25°C: 1000 mm²/s (Siliconöl AR1000, Wacker-Chemie GmbH) |
| VII | Poly(dimethylsiloxan), Hydroxy-terminiert, ca. 25 cSt bei 25°C (Sigma-Aldrich, Bestellnummer: 48,193-9) |
| VIII | Poly(dimethylsiloxan), Hydroxy-terminiert, ca. 65 cSt bei 25°C (Sigma-Aldrich, Bestellnummer: 48,195-5) |
| IX | Poly(dimethylsiloxan), Hydroxy-terminrert, 90-150 cSt bei 25°C (Sigma-Aldrich, Bestellnummer: 43,297-0) |
| X | Polydimethylsiloxan, Trimethylsilyl-terminiert Hampton-Research, DMS Oil, Bestellnummer:HR2-593 |
| XI | Poly-3,3,3-Triflurpropylmethylsiloxan Hampton-Research, FMS Oil, Bestellnummer:HR2-595 |
| XII | ((N-Pyrrolidonpropyl)-Methylsiloxan-Dimethylsiloxan-Copolymer (ABCR, Bestellnummer: YBD-125, Gelest Inc.) |
| XIII | Poly[dimethylsiloxan-Co-Methyl(3-Hydroxypropyl)siloxan]-graft-Poly(ethylenglycol)methylether (Sigma-Aldrich, Bestellnummer: 48,239-0) |
| XIV | Poly[dimethylsiloxan-Co-Methyl(3-Hydroxypropyl)siloxan]-Graft-Poly(ethylen/propylenglycol)methylether (Sigma-Aldrich, Bestellnummer: 48,034-7) |
| XV | Poly[dimethylsiloxan-Co-Methyl(3,3,3-Trifluorpropyl)siloxan] (Sigma-Aldrich, Bestellnummer: 48,257-9) |
| XVI | Dimethylsiloxan - Ethylenoxid Blockcopolymer (ABCR, Bestellnummer: DBE-224, Gelest Inc.) |

In runden Glasgefäßen mit einem Innendurchmesser von 6,5 mm werden je 500 Mikroliter der zu testenden Flüssigkeit gegeben, mit je 500 Mikroliter Paraffinöl bedeckt und bei Raumtemperatur inkubiert. Alle Flüssigkeiten bilden initial zum Paraffin eine scharfe Phasengrenze. Nach zwei Stunden hat die Phasengrenze für die Flüssigkeiten IV und X bereits an Schärfe verloren, bedingt durch ein ineinanderdiffundieren beider Flüssigkeiten. Nach 24 Stunden ist dies ansatzweise auch für die Flüssigkeit I der Fall. Somit stellen die Flüssigkeiten II, III, V, VI, VII, VIII, IX, XI, XII, XIII, XIV, XV und XVI potenzielle Kandidaten für die mittlere Phase des hier beschriebenen Verfahrens dar. Die Flüssigkeiten IV, X und bedingt I fallen aus dem hier vorgestellten Selektionsverfahren aus. Für die Flüssigkeit X ist dies nicht verwunderlich, da es sich um das in den modifizierten Batchverfahren verwendete Polydimethylsiloxan (DMS) handelt, was dem Paraffinöl beigesetzt wird um dieses diffusionsoffener zu machen. Die flüssigkeit X wurde exemplarisch berücksichtigt.

### Beispiel 2: Test der Diffusionseigenschaften der mittleren Phase

Die zu testenden mittleren Phasen werden mit Wasser abgesättigt. Dazu wird der zu testenden Flüssigkeit 5 % (v/v) Wasser zugegeben, vermischt, zentrifugiert und über mehrere Tage inkubiert. Die Absättigung dient dazu, die Bildung von Proteinkristallen durch Wasserentzug der zu testenden mittleren Phase zu unterbinden. Die Flüssigkeiten XIII, XIV und XVI erwiesen sich als wenig kompatibel mit einer wässrigen Lösung.

Eine Lysozymlösung (25 mg/ml) wird wie folgt hergestellt: 50 mg Lysozym (Lysozyme, Sigma; Bestellnummer: L-7651) werden komplett in 1 ml Wasser aufgelöst, filtriert und mit 1 ml der folgenden Lösung versetzt: 5 % NaCl, 100 mM NaOAc pH 4.0, 0.02 % NaN₃.

In eine 96-well Mikrotiterplatte werden pro Probengefäß 10 Mikroliter der Lysozymlösung deponiert und mit je 80 Mikroliter der in Beispiel 1 genannten Flüssigkeiten Nummer: II, III, V, VI, VII, VIII und IX überdeckt. Parallel dazu wird der gleiche Ansatz erstellt, und weiter mit 100 Mikroliter Paraffinöl überdeckt. Beide Ansätze werden bei 22°C inkubiert und über einen Zeitraum von mehreren Wochen beobachtet. Bei der Wahl der getesteten Flüssigkeiten wurden die kostengünstigen potenziellen Flüssigkeiten ausgewählt.

Die folgende Tabelle gibt die Zeiten in Tagen wieder, nach denen Lysozymkristalle beobachtet werden konnten:

| Flüssigkeit Nummer | ohne Paraffinöl | mit Paraffinöl |
|---|---|---|
| II | ∼8 | ∼22 |
| III | ∼8 | ∼22 |
| V | ∼6 | ∼22 |
| VI | ∼7 | ∼22 |
| VII | ∼0,5 | ∼22 |
| VIII | ∼1 | ∼22 |
| IX | ∼1 | ∼22 |

Somit können verschiedene Diffusionseigenschaften der Flüssigkeiten charakterisiert werden und deren Einfluss auf die Diffusionseigenschaften des Paraffinöls ausgeschlossen werden.

### Beispiel 3: Diffusionseigenschaften der Hvdroxy-terminierten Polydimethylsiloxane

Anstelle der in Beispiel 2 genannten Mikrotiterplatten werden Glasgefäße mit einem Innendurchmesser von 6,5 mm verwendet und mit 100 Mikroliter der aus Beispiel 1 genannten Flüssigkeiten Nummer VII, VIII oder IX befüllt. Parallel dazu wird der gleiche Ansatz erstellt, und weiter mit 100 Mikroliter Paraffinöl überdeckt. Anschließend werden den Glasröhrchen 5 Mikroliter der in Beispiel 2 beschriebenen Lysozymlösung beigefügt. Diese wandert zum Boden des Gefäßes. Innerhalb weniger Stunden wird bei Flüssigkeit VII deren leichte Eintrübung im mit Paraffin überdeckten Ansatz beobachtet. Nach mehreren Stunden ist diese Eintrübung ebenfalls für die mit Paraffinöl überdeckten Flüssigkeiten VIII und IX sichtbar. Diese Trübung bleibt für die nicht mit Paraffinöl überdeckten Ansätze aus. Wird den mit Paraffinöl überdeckten Ansätzen keine wässrige Phase beigefügt, bleibt eine Eintrübung aus. Wird an Stelle der Lysozymlösung reines Wasser verwendet, wird ein ähnliches Verhalten beobachtet. Die gemäß Beispiel 2 durchgeführte Absättigung der Flüssigkeiten ist insbesondere für die Hydroxy-terminierten-Dimethylsiloxane wichtig.

### Beispiel 4: Kristallisation von Lysozym im Vierphasensystem:

Aufbau des Vierphasensystems: Als untere Phase werden in Glasgefäßen mit 6,5 mm Innendurchmesser je 500 Mikroliter einer Lösung von 5 % NaCl, 100 mM NaOAc pH 4.0, 0.02 % NaN₃ gegeben. Die Lösung bestimmt somit den Endpunkt für die Kristallisation des Lysozyms. Anschließend werden als mittlere Phase 100 Mikroliter der in Beispiel 1 genannten Flüssigkeit Nummer V zugegeben. Überdeckt wird das ganze mit 100 Mikroliter Paraffinöl als obere Phase.

Ein Mikroliter einer Lysozymlösung gemäß Beispiel 2 wird mittels einer Pipette unter die Paraffin/Luft Phasengrenze in das Dreiphasensystem appliziert und wandert bedingt durch den Dichteunterschied bis zur Silikonöl/Paraffinöl Phasengrenze. Anschließend wandert die Proteinlösung langsam zur Phasengrenze untere Phase/Silikonöl und verbleibt dort üblicherweise als stabile vierte Phase in Form eines Tropfens. Der Endpunkt der Konzentration wird durch die Zusammensetzung der unteren Phase bestimmt. Gelegentlich wird auch eine unerwünschte Vereinigung der vierten Phase mit der unteren Phase beobachtet. Es bilden sich Proteinkristalle (Figur 4). Verwendet man anstelle der Flüssigkeit V die Flüssigkeit VI, so stabilisiert sich der Tropfen in der Regel an der Phasengrenze Paraffinöl/Silikonöl. Dies gilt insbesondere für Tropfen <1 Mikroliter. Es bilden sich ebenfalls Proteinkristalle.

Die in diesem Beispiel genannten Flüssigkeiten Nummer V und VI sind Copolymere. Sie unterscheiden sich in der Viskosität und somit in der Längenverteilung der jeweiligen Polymerketten. Es ist somit ersichtlich, dass die Länge- und Längenverteilung des Phenylmethylsiloxans, sowie das Volumen der Proteinlösung einen nicht unerheblichen Einfluss auf das Verhalten des Systems haben. Diese Parameter können je nach Anwendung eingestellt und optimiert werden. Auch über die Zugabe von Zusatzstoffen (z.B. Stabilisatoren, Block-Copolymere, insbesondere Di- und/oder Triblock-Copolymere) kann das System weiter optimiert werden.

Bei Verwendung von Glasröhrchen oder Glaskapillaren kann die Doppelbrechung der Proteinkristalle zur Detektion genutzt werden. Hierzu wird polarisiertes Licht mit einem 90° versetzten Analysator zur Totalextinktion gebracht, wobei Kristalle nicht-kubischer Symmetrie je nach Ausrichtung ein Lichtsignal zeigen (Figur 5). Der Teil des Probengefäßes, durch den der Lichtweg führt, muss dabei optisch homogen sein. Bei der Vorrichtung nach Figur 5 wurde durch die Seitenwände gemessen. Insbesondere bei Probenträgern mit einer Vielzahl von Probengefäßen ist es vorteilhaft, die Messung durch einen optisch homogenen Gefäßboden vorzunehmen. Des weiteren bilden sich bei der Verwendung von Glas an der Phasengrenze unten/Mitte sowie Mitte/oben jeweils ein konkaver Meniskus aus, was zu einer Zentrierung des Tropfens führt (siehe Figur 4). Dies ist für die Analyse der Kristallisationsexperimente von Vorteil. Die Oberflächeneigenschaften des Gefäßes können auf diese Art so ausgewählt werden, das sie das Verfahren vorteilhaft beeinflussen.

### Beispiel 5: Kristallisation im Vierphasensystem mit räumlicher Abtrennung der Proteinlösung von der unteren Phase

Ein Dreiphasensystem wird in einer 96-well Kristallisationsplatte (Greiner Bio-one, Protein Kristallisationsplatte, 96 well; Bestellnummer 609120) wie oben beschrieben etabliert. Dabei ist es wichtig, dass die untere Phase nicht über die Ausbuchtung hinausragt (siehe Figur 6). Die mittlere Phase wird dann appliziert, bis der gesamte Querschnitt einer Probenposition bedeckt ist. Anschließend wird mit Paraffinöl überdeckt (obere Phase, siehe Figur 6). Die mittlere Phase kann auch nach der oberen Phase appliziert werden.

Als Richtwerte gelten folgende Volumina: 300 Mikroliter Ausfällungsreagenz (siehe untere Phase Beispiel 4), 90 Mikroliter der mittleren Phase, 120 Mikroliter Paraffinöl und 2 Mikroliter Proteinlösung.

Die Ansprüche an die mittlere Phase sind bezüglich der Stabilisierung des Proteintropfens weniger stringent als bei Beispiel 4. Zwei Mikroliter einer in Beispiel 2 beschriebenen Lysozymlösung wir so appliziert, dass sie in die Ausbuchtung des Gefäßes positioniert ist oder dorthin wandert. Sie bildet einen Tropfen aus, der von der mittleren Phase und der Gefäßwand umgeben ist. Die Figur 7 zeigt ein Kristallisationsexperiment bei dem die Flüssigkeit IX als mittlere Phase verwendet wurde. Proteinkristalle bilden sich im Falle der Flüssigkeit IX nach zwei Tagen. Bei Verwendung der Hydroxy-terminierten-Polysiloxane (Flüssigkeiten VII, VIII und IX) kann des öfteren ein Aufreißen der oberen Paraffinschicht beobachtet werden, insbesondere wenn geringere Volumina des Paraffinöl verwendet werden. Die hier verwendete Kristallisationsplatte lässt jedoch keine Applikation von größeren Mengen Paraffinöl zu. Dagegen erlaubt die Verwendung eines Probenträgers mit einem erhöhten Rand die Applikation einer ausreichenden Schicht Paraffinöls über den gesamten Probenträger.

### Beispiel 6: Vergleichende Kristallisation von weiteren Enzymen - Glucose Isomerase und Xylanase

Das Verfahren wurde mittels zwei kommerziell erhältlicher Enzyme realisiert, namentlich der Glucose Isomerase (Hampton-Research, Glucose Isomerase, Bestellnummer:HR7-100) und der Xylanase (Hampton-Research, Xylanase, Bestellnummer:HR7-106). Beide Proteine wurden bei einer Konzentration von 15 mg/ml, sowie mittels eines etablierten und kommerziell erhältlichen Kits von Ausfällungsreagenzien (Hampton-Research, crystal screen, HR2-110) (nach Jancarik, J. und Kim, S.H.; Sparse matrix sampling: a screening method for crystallization of proteins; J. Apil. Cryst. 1991, 24, 409-11) getestet. Die Ausfällungsreagenzien wurden sowohl unverdünnt als auch in 50%iger Verdünnung verwendet. Die Proteinlösung wurde filtriert.

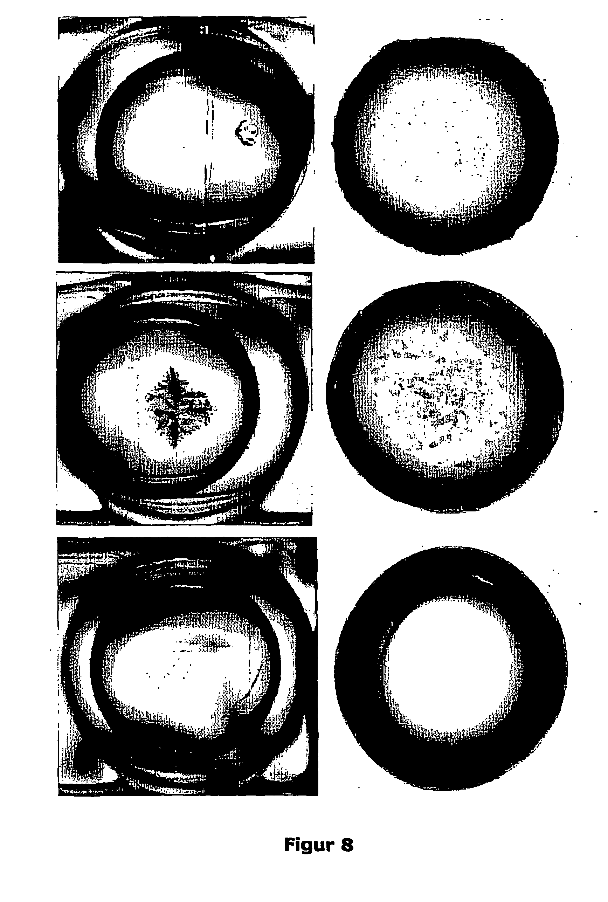

Ein Dreiphasensystem wird in einer mit erhöhtem Rand ausgestatteten 96-well Kristallisationsplatte realisiert (Greiner Bio-one, Protein Kristallisationsplatte, 96 well; Bestellnummer 609120). Der Rand wurde mittels Ankleben eines Plastikstreifens von ∼2cm erzeugt und mit Heißkleber abgedichtet. Das Dreiphasensystem wird aufgebaut, indem zuerst Paraffinöl über die Gesammtheit der Probenträger hinweg appliziert wird und anschließend die verschiedenen Ausfällungsreagenzien einzeln in je ein Reservoir gegeben werden. Anschließend wird ein Tropfen der Ausfällungsreagenz von 1,5 µl Volumen in jedes der drei Ausbuchtungen aus dem Reservoir heraus pipettiert. Anschließend wird die Phase II appliziert, indem soviel der Flüssigkeit VIII aus Beispiel 1 zugegeben wird, bis der gesamte Querschnitt einer jeden Probenposition bedeckt ist, jedoch nicht über den Rand der Probenposition hinaus. Die Platte wird anschließend zwei Stunden inkubiert. Anschließend wird jeder Ausbuchtung 1,5 µl der wässrigen Proteinlösung zugegeben. Parallel zu diesem Experiment wird ein klassisches Hanging-Drop Experiment angesetzt. Nach 18 Stunden wurden Bilder der Ansätze aufgenommen. Figur 8 zeigt einen Vergleich zwischen der Methode des Dreiphasensystems und dem Hängenden Tropfen. In mehr als 50% der Fällen zeigte die Methode der 3 Phasen eindeutig besser ausgebildete Kristalle. Des weiteren konnte gezeigt werden, dass der Aufbau des Dreiphasensystems unter Verwendung der Flüssigkeit VIII aus Beispiel 1 mit allen 50 Lösungen des Screens kompatibel ist. Die Ausfällungsreagenzien bestehen aus einer Auswahl typischerweise in der Proteinkristallisation verwendeter Substanzen und beinhalten ebenfalls organische Lösungsmittel.

Figur 8 zeigt exemplarisch anhand von drei Konditionen einen Vergleich der in Beispiel 6 generierten Resultate zwischen dem neuen Verfahren (linke Spalte) und dem klassischen Hängenden-Tropfen (rechte Spalte). Die erste und zweite Reihe gibt Resultate der Glucose Isomerase und die letzte Reihe ein Resultat der Xylanase. Die hier gezeigten Beispiele zeigen das im Rahmen des neuen Verfahrens oft bessere Resultate erhalten werden als mit klassischen Verfahren.

## Patentansprüche

1. Verfahren zur Kristallisation von Makromolekülen in einem Dreiphasensystem unter Verwendung eines Gefäßes, enthaltend eine untere wässrige Phase, eine mittlere Phase und eine obere hydrophobe Phase mit geringerer Dichte als die untere wässrige Phase, wobei
• eine wässrige Lösung der Makromoleküle in die mittlere Phase gegeben wird und eine vierte Phase bildet und inkubiert wird,
• die wässrige Lösung der Makromoleküle eine vierte Phase bildet, die sich nicht unmittelbar mit der unteren Phase vermischt,
• sich die vierte Phase solange nicht vollständig mit der unteren Phase vermischt, bis die Kristallisation in der vierten Phase oder an einer Phasengrenze zur vierten Phase einsetzt,
• durch die obere Phase über die Dauer des Kristallisationsvorgangs im wesentlichen keine Diffusion von Wasser aus dem Gefäß stattfindet,
• und die mittlere Phase so ausgewählt ist, dass eine Diffusion von Wasser von der vierten Phase in die untere Phase stattfindet.

2. Verfahren nach Anspruch 1, **dadurch gekennzeichnet, dass** die wässrige untere Phase durch eine hygroskopische Festphase ersetzt ist.

3. Verfahren nach Anspruch 1, **dadurch gekennzeichnet, dass** die untere Phase eine hygroskopische Flüssigphase ist.

4. Verfahren nach mindestens einem der Ansprüche 1. bis 3, **dadurch gekennzeichnet, dass** die vierte Phase nach Einbringen in das Gefäß zur Phasengrenze zwischen der unteren und mittleren Phase oder zur Phasengrenze zwischen der mittleren und oberen Phase wandert.

5. Verfahren nach mindestens einem der Ansprüche 1 bis 4, **dadurch gekennzeichnet, dass** das Gefäß so ausgestaltet ist, das die vierte Phase nicht in Kontakt mit der unteren Phase kommt.

6. Verfahren nach Anspruch 5, **dadurch gekennzeichnet, dass** die vierte Phase in einer Ausbuchtung lokalisiert ist.

7. Verfahren nach mindestens einem der Ansprüche 1 bis 6, **dadurch gekennzeichnet, dass** die obere Phase Paraffinöl enthält.

8. Verfahren nach mindestens einem der Ansprüche 1 bis 7, **dadurch gekennzeichnet, dass** die mittlere Phase Hydroxy-terminiertes Polydimethylsiloxan und/oder Phenylmethyl-Sillconöl enthält.

9. Verfahren nach mindestens einem der Ansprüche 1 bis 8, **dadurch gekennzeichnet, dass** die untere wässrige Phase Salze, Puffersubstanzen, Polymere und/oder organische Lösungsmittel enthält.

10. Verfahren nach mindestens einem der Ansprüche 1 bis 9, **dadurch gekennzeichnet, dass** die Lösung des Makromoleküls Salze, Puffersubstanzen, Polymere und/oder organische Lösungsmittel enthält.

11. Verfahren nach mindestens einem der Ansprüche 1 bis 10, **dadurch gekennzeichnet, dass** die Makromoleküle Proteine, DNA, RNA, Komplexe von Makromolekülen, Proteinkomplexe; Protein/Ligandenkomplexe, DNA/Ligandenkomplexe, Protein/RNA-Komplexe, Protein/DNA-Komplexe, Viren oder Virenfragmente sind.

12. Verfahren nach mindestens einem der Ansprüche 1 bis 11, **dadurch gekennzeichnet, dass** die Kristallisation durch optische Messverfahren, insbesondere mikroskopische Aufnahmen, Streulichtverfahren oder spektroskopische Methoden analysiert und/oder kontinuierlich verfolgt wird.

13. Vorrichtung zur Kristallisation von Makromolekülen, bei der eine Vielzahl von Probengefäßen (6, 16) zu einem Probenträgern angeordnet sind, wobei der Probenträger einen durchgängigen umlanfenden Rand (2) aufweist, der höher angeordnet ist als die Öffnungen der Probengefäße und bei der in jedem Probengefäß (6, 16) mindestens ein Teilbereich (5, 15) vorhanden ist, der von dem übrigen Probengefäß durch seitliche Wände (3, 13) abgetrennt ist, wobei die seitlichen Wände in den Probengefäßen (3, 13) nach oben hin niedriger sind als die seitlichen Wände des Probengefäßes (4, 14).

14. Vorrichtung nach Anspruch 13, wobei der Boden (1) der Teilbereiche (5) auf derselben Höhe liegt wie der Boden der Probengefäße (6).

15. Vorrichtung nach Anspruch 13 und/oder 14, wobei der Boden des Probenträgers optisch homogen ist.

16. Vorrichtung zur Kristallisation von Makromolekülen nach einem der Ansprüche 13 bis 15, **dadurch gekennzeichnet, dass** der Boden des Probenträgers optisch homogen ist und dass der Boden (1) der Teilbereiche (5) auf derselben Höhe liegt wie der Boden der Probengefäße (6).

## Claims

1. A method for the crystallization of macromolecules in a three-phase system using a vessel containing a lower aqueous phase, a middle phase and an upper hydrophobic phase having a lower density than that of the lower aqueous phase, wherein
• an aqueous solution of the macromolecules is added to the middle phase to form a fourth phase, followed by incubation;
• said aqueous solution of macromolecules forms a fourth phase which does not immediately mix with the lower phase;
• said fourth phase does not mix completely with the lower phase until the crystallization begins in the fourth phase or at a phase boundary with the fourth phase;
• there is essentially no diffusion of water from the vessel through the upper phase over the duration of the crystallization process; and
• said middle phase is selected to have a diffusion of water from the fourth phase into the lower phase.

2. The method according to claim 1, **characterized in that** said aqueous lower phase has been replaced by a hygroscopic solid phase.

3. The method according to claim 1, **characterized in that** said lower phase is a hygroscopic liquid phase.

4. The method according to at least one of claims 1 to 3, **characterized in that** said fourth phase migrates to the phase boundary between the lower and middle phases or to the phase boundary between the middle and upper phases after having been introduced into the vessel.

5. The method according to at least one of claims 1 to 4, **characterized in that** the vessel is designed in such a way that the fourth phase does not come into contact with the lower phase.

6. The method according to claim 5, **characterized in that** said fourth phase is located in an indentation.

7. The method according to at least one of claims 1 to 6, **characterized in that** said upper phase contains paraffin oil.

8. The method according to at least one of claims 1 to 7, **characterized in that** said middle phase contains hydroxy-terminated polydimethylsiloxane and/or phenylmethylsilicone oil.

9. The method according to at least one of claims 1 to 8, **characterized in that** said lower aqueous phase contains salts, buffer substances, polymers and/or organic solvents.

10. The method according to at least one of claims 1 to 9, **characterized in that** said solution of the macromolecule contains salts, buffer substances, polymers and/or organic solvents.

11. The method according to at least one of claims 1 to 10, **characterized in that** said macromolecules are proteins, DNA, RNA, complexes of macromolecules, protein complexes, protein/ligand complexes, DNA/ligand complexes, protein/RNA complexes, protein/DNA complexes, viruses or viral fragments.

12. The method according to at least one of claims 1 to 11, **characterized in that** the crystallization is analyzed and/or continuously monitored by optical measuring methods, especially microphotographs, light scattering methods or spectroscopic methods.

13. A device for the crystallization of macromolecules in which a multitude of sample vessels (6, 16) are arranged to form a sample support, wherein said sample support has a contiguous circumferential edge (2) which is higher than the openings of the sample vessels, and in which at least one subsection (5, 15) separated from the remaining sample vessel by lateral walls (3, 13) exists in each sample vessel (6, 16), wherein the top portions of the lateral walls (3, 13) are upwardly lower than the lateral walls of the sample vessel (4, 14).

14. The device according to claim 13, wherein the bottom (1) of the subsections (5) is at the same level as the bottom of the sample vessels (6).

15. The device according to claim 13 and/or 14, wherein the bottom of the sample support is optically homogeneous.

16. The device for the crystallization of macromolecules according to any of claims 13 to 15, **characterized in that** the bottom of the sample support is optically homogeneous, and the bottom (1) of the subsections (5) is at the same level as the bottom of the sample vessels (6).

## Revendications

1. Procédé de cristallisation de macromolécules dans un système à trois phases avec utilisation d'un vase, contenant une phase aqueuse inférieure, une phase médiane et une phase hydrophobe supérieure ayant une densité inférieure à celle de la phase aqueuse inférieure,
• une solution aqueuse des macromolécules étant fournie dans la phase médiane, et une quatrième phase étant formée et incubée,
• la solution aqueuse des macromolécules formant une quatrième phase qui ne se mélange pas immédiatement avec la phase inférieure,
• la quatrième phase ne se mélangeant pas complètement avec la phase inférieure avant le début de la cristallisation dans la quatrième phase ou au niveau d'une limite de phase vers la quatrième phase,
• aucune diffusion d'eau à partir du vase n'intervenant du fait de la phase supérieure pendant la durée du processus de cristallisation,
• et la phase médiane étant sélectionnée de sorte qu'une diffusion d'eau intervient de la quatrième phase dans la phase inférieure.

2. Procédé selon la revendication 1, **caractérisé en ce que** la phase inférieure aqueuse est remplacée par une phase solide hygroscopique.

3. Procédé selon la revendication 1, **caractérisé en ce que** la phase inférieure est une phase liquide hygroscopique.

4. Procédé selon au moins l'une des revendications 1 à 3, **caractérisé en ce que**, après l'introduction dans le vase, la quatrième phase migre vers la limite de phase entre la phase inférieure et la phase médiane ou vers la limite de phase entre la phase médiane et la phase supérieure.

5. Procédé selon au moins l'une des revendications 1 à 4, **caractérisé en ce que** le vase est constitué de sorte que la quatrième phase n'entre pas en contact avec la phase inférieure.

6. Procédé selon la revendication 5, **caractérisé en ce que** la quatrième phase est localisée dans un évasement.

7. Procédé selon au moins l'une des revendications 1 à 6, **caractérisé en ce que** la phase supérieure contient de l'huile de paraffine.

8. Procédé selon au moins l'une des revendications 1 à 7, **caractérisé en ce que** la phase médiane contient de l'huile de phénylméthyl-silicone et/ou du poly(diméthylsiloxane) hydroxy-terminé.

9. Procédé selon au moins l'une des revendications 1 à 8, **caractérisé en ce que** la phase aqueuse inférieure contient des sels, des substances tampons, des polymères et/ou des solvants organiques.

10. Procédé selon au moins l'une des revendications 1 à 9, **caractérisé en ce que** la solution de la macromolécule contient des sels, des substances tampons, des polymères et/ou des solvants organiques.

11. Procédé selon au moins l'une des revendications 1 à 10, **caractérisé en ce que** les macromolécules sont des protéines, de l'ADN, de l'ARN, des complexes de macromolécules, des complexes de protéines, des complexes protéines/ligands, des complexes ADN/ligands, des complexes protéines/ARN, des complexes protéines/ADN, des virus ou des fragments de virus.

12. Procédé selon au moins l'une des revendications 1 à 11, **caractérisé en ce que** la cristallisation est analysée et/ou suivie en continu par des procédés de mesure optiques, en particulier des photos microscopiques, des procédés de lumière diffusée ou des méthodes spectroscopiques.

13. Dispositif pour la cristallisation de macromolécules, avec lequel une multiplicité de vases d'essai (6, 16) sont disposés sur un porte-échantillons, le porte-échantillons présentant un bord (2) périphérique continu qui est disposé plus haut que les ouvertures des vases d'essai, et dans lequel il y a, dans chaque vase d'essai (6, 16), au moins l'une zone partielle (5, 15) qui est séparée du reste du vase d'essai par des parois latérales (3, 13), les parois latérales dans les vases d'essai (3, 13) étant, en partie haute, plus basses que les parois latérales du vase d'essai (4, 14).

14. Dispositif selon la revendication 13, **caractérisé en ce que** le fond (1) des zones partielles (5) est à la même hauteur que le fond des vases d'essai (6).

15. Dispositif selon la revendication 13 et/ou 14, **caractérisé en ce que** le fond du porte-échantillons est optiquement homogène.

16. Dispositif pour la cristallisation de macromolécules selon une des revendications 13 à 15, **caractérisé en ce que** le fond du porte-échantillons est optiquement homogène, et **en ce que** le fond (1) des zones partielles (5) est à la même hauteur que le fond des vases d'essai (6).
